# EUROPEAN PATENT SPECIFICATION

(11) **EP 1 890 336 B1**
(45) Date of publication and mention of the grant of the patent: **02.11.2011**
(21) Application number: 06017292.1
(22) Date of filing: 18.08.2006
(51) Int. Cl.: H01L 29/78, H01L 21/336, H01L 29/06, H01L 29/08, H01L 29/10, H01L 29/423

(54) **High-voltage MOS transistor device and method of making the same**
Hochspannungs-MOS-Transistoranordnung und Verfahren zu deren Herstellung
Dispositif à transistor MOS à haute tension et sa méthode de fabrication

(43) Date of publication of application: 20.02.2008
(73) Proprietor: austriamicrosystems AG, 8141 Unterpremstätten (AT)
(72) Inventor: Park, Jong Mun, 8010 Graz (AT); Röhrer, Georg, 8010 Graz (AT); Knaipp, Martin, 8141 Unterpremstätten (AT)
(74) Representative: Epping - Hermann - Fischer

(56) References cited:
- WO-A1-01/11681
- DE-A1-102004 014 928
- US-A1- 2002 072 186
- US-B1- 6 677 210
- KHEMKA V ET AL: "NOVEL FRESURF LDMOSFET DEVICES WITH IMPROVED BVDSS-RDSON" IEEE ELECTRON DEVICE LETTERS, IEEE SERVICE CENTER, NEW YORK, NY, US, vol. 25, no. 12, 12 December 2004 (2004-12-12), pages 804-806, XP001212073 ISSN: 0741-3106
- BOSE A; KHEMKA V; PARTHASARATHY V; RONGHUA ZHU: "A floating resurf (fresurf) ld-mosfet device concept", IEEE ELECTRON DEVICE LETTERS, vol. 24, no. 10, 1 October 2003 (2003-10-01), pages 664-666, XP011101817, IEEE SERVICE CENTER, NEW YORK, NY, US

## Description

The present invention concerns a high-voltage MOS transistor device, especially a PMOS transistor having an improved well structure. The invention also discloses a preferred method of production. In a further aspect, the invention describes an implementation of a lateral high-voltage PMOS transistor in a high-voltage process technology. A well configuration is described which renders an optimal compromise between a sufficient blocking voltage and a low on-resistance.

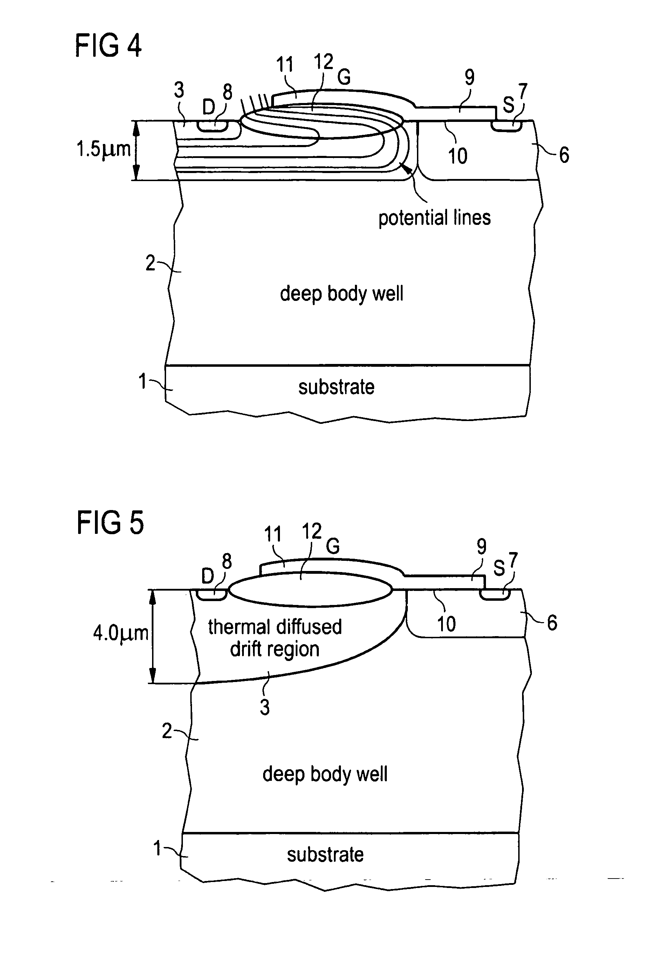

In developing a well concept for a lateral high-voltage PMOS transistor, several constraints must be taken into account. The appended figure 4 shows a cross section of a typical lateral PMOS transistor. A semiconductor substrate 1 is provided with a body well 2, which is n-conductively doped in the case of a PMOS transistor. A diffused drift well region 3 is provided between a diffused channel well region 6, including a source region 7, and a drain region 8. The diffused channel well region 6 is n-conductive, whereas the drift well region 3 is p-conductive.

In the example shown in figure 4, the body well 2 is formed comparatively deep, while the diffused drift well region 3 is rather shallow. The approach to provide a deep body well 2, which is favorable for the integration of a number of different high-voltage devices on the same substrate, leads to the steep decrease of the electric potential as indicated by the potential lines shown in figure 4. The resulting vertical electric field is high in a region under the drain region 8, where the potential drops mainly within a small distance in the vertical direction. Therefore, if the deep body well 2 is highly doped and a local high-energy implant is provided for the drift region having a depth of typically 1.5 µm, the voltage drop is inside the drift region and the breakdown voltage of the device is limited to small values.

Figure 5 shows a possible modification of the device structure according to figure 4. The device according to figure 5 comprises a diffused drift well region 3 which is thermally diffused to a depth of 4.0 µm. The deeper diffused drift well region allows a higher blocking voltage. Unfortunately this results in an undefined channel threshold voltage, because the thermally diffused region extends into the diffused channel well region 6 so that the channel doping profile is influenced by the diffused doping atoms, in the case of a PMOS transistor usually boron atoms. As a consequence, it is not possible to define a very short channel length precisely.

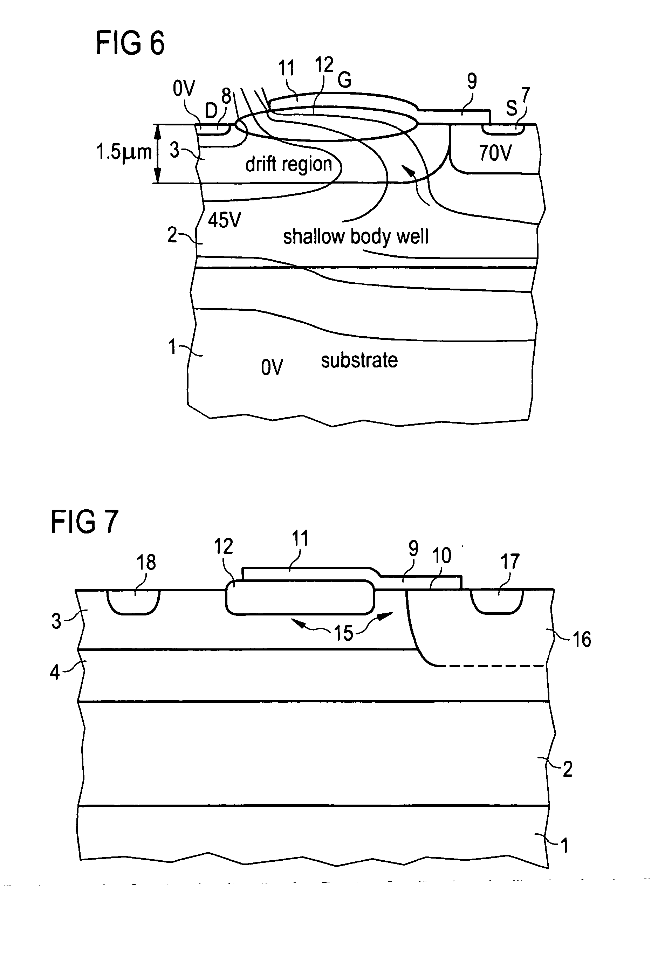

If a shallow body well is used, according to the structure shown in figure 6, the breakdown voltage and the channel threshold voltage are clearly defined, but the drift region cannot be depleted during the operation of the device, which results in a higher on-resistance.

Therefore, the three main constraints of an optimal well configuration, which are contradictory, are, first, the requirement of an efficient depletion of the drift region, which may be achieved by the highest possible local donor concentration in the body well below the drift region; second, the requirement of a sufficient limitation of the drift acceptor dopants towards the channel region, which may be achieved by the formation of a localized drift region using a low thermal budget, which also ensures a well-defined threshold voltage; and, third, the requirement that a region below the drain contact is provided for the voltage to drop in vertical direction from V_{DD} to V_{SS}, this region having a sufficient size to keep the electric field strength below a critical value. These contradictory constraints hinder an increase of the depth of the body well as shown in figures 4 and 5.

US 6,677,210 B1 describes high voltage transistors with graded extension, in which an N-well is located under an N⁺-doped drain region adjacent to a shallower HV P-well extending a P-well. An N-doped drift region is located between drain and a channel region of the P-well at an upper surface above the N-well and the HV P-well.

A paper of V. Khemka et al. in IEEE Electron Device Letters, vol. 25 (2004), no. 12, pages 804-806 describes, in the context of a device with improved breakdown voltage, a P-region located in a P-substrate underneath the drain drift region.

It is an object of this invention to disclose an improved structure of a lateral high-voltage MOS transistor which allows the integration of different devices, provides a high blocking voltage, permits a precisely defined short channel length and keeps the on-resistance sufficiently low. It is a further object of this invention to disclose an especially suitable method of production.

This is achieved by the high-voltage MOS transistor device comprising the features of the limitations of claim 1, and the method of production comprising the method steps according to the limitations of claim 5, respectively. Further embodiments, alterations and substitutions emerge from the dependent claims.

In the high-voltage MOS transistor device two additional wells are used to design the drift region. A deep body well is disposed below the drift region. The body well thus offers a high donor concentration to deplete the drift region near the bird's beak facing the channel region. A deep well of a conductivity type that is opposite to the conductivity type of the deep body well is placed under the draim region to form a region where the body/drain potential can drop. This MOS transistor device is especially favorable as a PMOS transistor, but the signs of the conductivity types can be selected either way. A main advantage of the new structure is the possibility to combine it with other devices, especially high-voltage devices, which are manufactured in the same process.

The comparatively very deep body well, which is n-conductive in the example of a PMOS transistor, can also be used to form a well of fully-isolated NMOS transistors. The deep n-well is appropriate for the location of a deep p-well having a junction depth of typically 4 µm, which is a basic structure element of a high-voltage device. It also allows the layout of isolated high-voltage diodes and fully isolated high-voltage transistors with an extended voltage range. The PMOS transistor can use the implant that is intended for the drain drift region of an integrated fully isolated NMOS transistor. The deep p-well can be used for various isolated devices like high-voltage diodes, high-voltage vertical bipolars and the already mentioned fully isolated high-voltage NMOS transistors. The above mentioned problems concerning the voltage drop near the drain region are circumvented by the arrangement of the comparatively deep drain well region below the drain region; the drain well region is doped for the same conductivity type as the drift region.

An optional field plate, preferably of polysilicon like the gate electrode, can be disposed above the drift region. An oxide between the field plate and the drift region can be processed by a standard field oxidation, a formation of a shallow trench isolation, or by depositing and structuring an oxide layer.

Examples of the device and the production method are described in the following in conjunction with the appended figures.
- Figure 1: shows a cross section of an embodiment of the tran- sistor device of the present invention.
- Figure 2: shows a cross section of a first intermediate prod- uct of a preferred method of production according to the prior art.
- Figure 3: shows a cross section according to figure 2 after the implantation of a further well.
- Figure 4: shows a cross section of a conventional high- voltage MOS transistor with increased depth of the body well.
- Figure 5: shows a cross section according to figure 4 for an alternative design according to the prior art with deep diffused drift region.
- Figure 6: shows a cross section and the equipotential lines of a conventional high-voltage MOS transistor with a shallow body well.
- Figure 7: shows a cross section of a further high-voltage MOS transistor device that can be integrated with an embodiment according to figure 1.

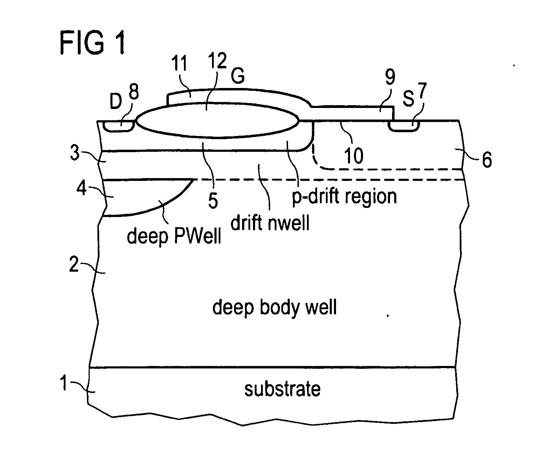

Figure 1 shows a cross section of an embodiment of the high-voltage MOS transistor device. As the preferred embodiment is a high-voltage PMOS transistor device, the signs of the conductivity types are chosen accordingly. To facilitate the reading of the figures, the boundaries between regions of the same sign of conductivity are indicated with broken lines. The continuous lines designate the limit between regions of opposite signs of conductivity. This does not apply to the small boundaries indicated for source and drain.

The semiconductor substrate 1 is provided with a body well 2 of a first conductivity type at a surface, which is indicated by the horizontal line on top of figure 1. The body well 2 is n-conductively doped in the case of a PMOS transistor and is formed to a depth that is typically larger than 7 µm and can be 10 µm or even more below the substrate surface. A depth of the drain well region 4 is preferably between 2 µm and 6 µm. A drift well region 3 of the same conductivity type as the body well 2 is formed in the upper portions of the body well 2 under the substrate surface. At the surface, a drift region 5 and a channel well region 6 are formed adjacent to one another, the channel well region 6 having the same conductivity as the drain well region 4, whereas the drift region 5 is doped for an opposite conductivity type. In the case of a PMOS transistor the channel well region 6 is n-conductive, and the drift region 5 is p-conductive.

The source region 7 and the drain region 8 are of the same conductivity type as the drift region 5 and are arranged as shown in figure 1. The source region 7 is disposed at the surface within the channel well region 6 at a distance from the drift region 5. The drain region 8 is arranged adjacent to the drift region 5 within a region of the same conductivity type, but lower doping concentration.

Between the source region 7 and the drift region 5 a channel region is provided at the surface of the channel well region 6. On the area of the channel region a gate electrode 9 is disposed, which is electrically insulated from the semiconductor material by a gate dielectric 10. Optionally a field plate 11 can be arranged on an oxide layer 12 above the drift region 5. The field plate 11 is electrically connected to the gate electrode 9. Both the gate electrode 9 and the field plate 11 can be formed of electrically conductively doped polysilicon. The oxide layer 12 can be a conventional field oxide or a shallow trench isolation. Also, an oxide layer can be deposited and structured according to the lateral dimensions of the oxide layer 12.

The operation of the device is optimized by a drain well region 4, which has a larger distance from the surface into the body well 2 than the counter drift well region 3 and is localized under the drain region 8. The drain well region 4 is formed by the introduction of doping atoms that are provided for the same conductivity type as the drift region 5. In the case of a PMOS transistor, the conductivity type of the drain well region 4 is p-conductivity. The drain well region 4 is arranged under the drain region and below the drift well region

Figure 1 gives an example, in which the volume that is occupied by the drain well region 4 shows a net p-conductivity in the body well 2, but not within the counter drift well region 3. The drain well region 4 enhances the drift doping concentration in the corresponding area of the drift region 5. The net doping in the overlap region, where both the counter drift well region 3 and the drain well region 4 are formed, produces a net conductivity of the same type as the counter drift well region 3.

In this embodiment, the voltage drop in the vertical direction underneath the drain region 8 takes place along a larger distance than in a conventional high-voltage MOS transistor, because the region provided for the voltage drop reaches deeper into the body well 2. Thus, an effect that is comparable to the effect of the thermally diffused drift region according to the cross section of figure 5 is achieved.

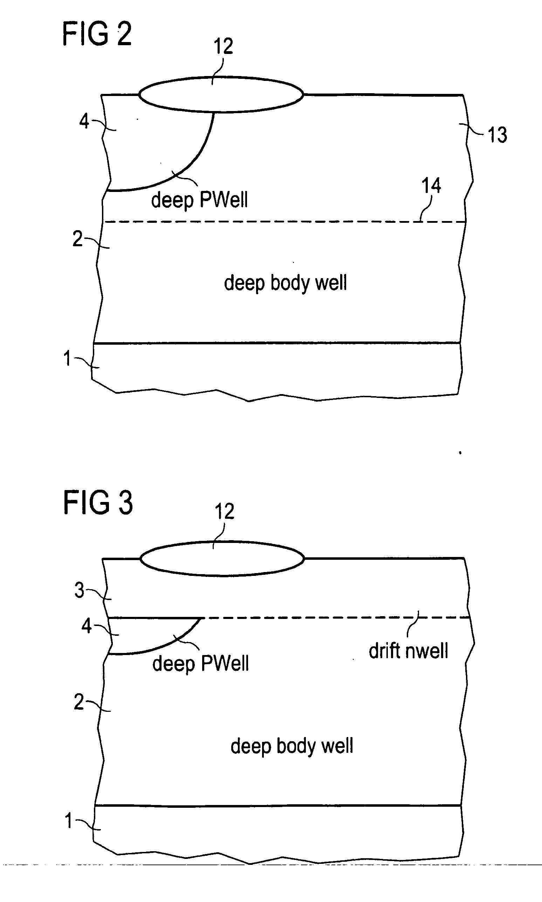

Figure 2 shows a production stage of a preferred method. A substrate 1 of semiconductor material is provided with a deep body well 2, in this example by an introduction of a dopant that is provided for n-conductivity. In a preferred variant of this method, an epitaxial layer 13 of the semiconductor material is grown on the original substrate surface 14. This epitaxial growth takes place after the implantion of the donor atoms that are provided for the body well 2. In this fashion the dopant reaches a larger depth below the final substrate surface without requiring a larger implantation energy. The subsequent diffusion of the implanted dopant forms the body well 2 occupying the total region up to the final substrate surface, including the volume of the epitaxial layer 13. In this manner, a very deep body well 2 can be produced using only an epitaxial step. Instead, the epitaxial layer 13 can be dispensed with if the implantation dose is selected sufficiently high. After the optional application of an epitaxial layer 13 and in any case before the diffusion of the dopant, a further dopant is implanted, which is provided for the drain well region 4 and which is subsequently diffused together with the dopant of the body well 2.

In later process steps, an oxide layer 12 can be formed, if desired. The oxide layer 12 can be formed by a standard field oxidation or by a process by which shallow trench isolations are formed in a state-of-the-art way. In another way, the oxide can also be deposited and subsequently structured. Device components that are only optional are shown in all the figures in the same shape in order to make the differences between the embodiments obvious; however, these components can be substituted with equivalents or completely left out.

Then, according to the cross section of figure 3, a further dopant is implanted to form the drift well region 3, thus enhancing the doping concentration of the upper part of the body well 2. The upper portion of the drain well region 4 is counterdoped by the implantation.

Then a shallower implantation is performed to produce the drift region 5 according to the cross section of figure 1, and the channel well region 6, the source region 7 and the drain region 8 are formed. The gate dielectric and the gate electrode are applied in the conventional way. This renders the device according to figure 1.

Figure 7 shows a further device, an NMOS transistor, which can be integrated together with a device according to figure 1 on the basis of the implanted wells. The device of figure 7 uses the counter drift well region 3 as a drift path from the channel region to the drain region 18. The diffused channel well region 16 has the opposite sign of conductivity as the counter drift well region 3. In an NMOS transistor, the channel well region 16 is p-conductive, and the counter drift well region 3 is n-conductive. The volume that is occupied by the drain well region 4 has a net p-conductivity and forms a region which fully isolates the transistor structure from the substrate. The channel well region 16 has the same sign of conductivity as the drain well region 4, as indicated by the broken line in figure 7. The source region 17 is disposed within the channel well region 16 and is of the opposite conductivity, n-conductive in the case of an NMOS transistor. The drain region 18 is disposed in the counter drift well region 3 and has the same sign of conductivity as the source region 17. Thus the wells forming the counter drift well region 3 and the drain well region 4 are ideally suited to the formation of different transistor structures, as well as other high-voltage devices such as high-voltage diodes or vertical high-voltage bipolar transistors.

## Claims

1. High-voltage MOS transistor device comprising:
- a body well (2) of n-type conductivity positioned near a surface of a semiconductor substrate (1),
- a drift well region (3) of n-type conductivity positioned in the body well (2),
- a drift region (5) of p-type conductivity positioned at the surface of the substrate in the drift well region (3),
- a channel well region (6) of n-type conductivity positioned at the surface of the substrate in the drift well region (3) and adjacent to the drift region (5),
- a source region (7) disposed at the surface within the channel well region (6) and at a distance from the drift region (5),
- a drain region (8) disposed at the surface within the drift region (5) at a distance from the channel well region (6),
- a drain well region (4) of p-type conductivity positioned under the drain region (8) and below the drift well region (3) in the body well (2), and
- a gate electrode (9) disposed above the channel well region (6) on an area of the channel well region (6) between the source region (7) and the drift region (5), the gate electrode (9) being electrically insulated from the semiconductor material by a gate dielectric (10).

2. The high-voltaqe MOS transistor device of claim 1, further comprising:
- at least one fully isolated high-voltage NMOS transistor being integrated in the substrate (1),
- the drift well region (3) being provided for a drift region of the NMOS transistor, and
- a portion of the drain well region (4) providing a body well of the NMOS transistor.

3. The high-voltage MOS transistor device of claim 1 or 2, further comprising:
at least one further high-voltage device selected from the group consisting of NMOS transistor, PMOS transistor, diode and bipolar transistor being integrated in the substrate (1), said further high-voltage device encompassing a pn-junction formed by the drift well region (3) and the drain well region (4).

4. The high-voltage MOS transistor device according to one of claims 1 to 3, wherein
a vertical dimension of the body well (2), vertical with respect to the surface of the substrate, is larger than 7 µm and
a depth of the drain well region (4) is between 2 µm and 6 µm.

5. Method of production of a high-voltage MOS transistor device, comprising:
- providing a semiconductor substrate (1) with a body well (2) of n-type conductivity,
- implanting a dopant provided for p-type conductivity into the body well (2) to a shallower depth than the body well (2) and forming a drain well region (4) which is laterally limited,
- implanting a dopant provided for n-type conductivity into the body well (2) to a shallower depth than the drain well region (4) and forming a drift well region (3), wherein the implant forming said drift well region (3) connterdopes the upper portion of said drain well region (4),
- implanting a dopant provided for p-type conductivity into the drift well region (3) and forming a drift region (5), and
- forming a channel well region (6) of n-type conductivity adjacent to the drift region (5), a source region (7) within the channel well region (6), and a drain region (8) adjacent to the drift region (5) and within the area originally occupied by the drain well region (4).

6. The method of claim 5, further comprising:
growing an epitaxial layer (13) of semiconductor material on the surface of the substrate (1), after having provided the body well (2) and before implanting the drain well region (4), and
effecting a diffusion of a dopant from the body well (2) into the epitaxial layer (13) after the implantation of the drain well region (4).

7. The method of claim 5 or 6, wherein
the implantation provided for the formation of the drain well region (4) is performed in such a manner that a drain well region (4) of a PMOS transistor and a deep well of an NMOS transistor are produced, and
the implantation provided for the formation of the drift well region (3) is performed in such a manner that a drift well region (3) of a PMOS transistor and a drift region of an NMOS transistor are produced.

## Patentansprüche

1. Hochspannungs-MOS-Transistorvorrichtug, Folgendes umfassend:
- eine Körperwanne (2) mit Leitfähigkeit des n-Typs, die sich nahe einer Oberfläche eines Halbleitersubstrats (1) befindet,
- eine Drift-Wannenzone (3) mit Leitfähigkeit des n-Typs, die sich in der Körperwanne (2) befindet,
- eine Drift-Zone (5) mit Leitfähigkeit des p-Typs, die sich an der Oberfläche des Substrats in der Drift-Wannenzone (3) befindet,
- eine Kanalwannenzone (6) mit Leitfähigkeit des n-Typs, die sich an der Oberfläche des Substrats in der Drift-Wannenzone (3) und angrenzend an die Drift-Zone (5) befindet,
- eine Source-Zone (7), die an der Oberfläche innerhalb der Kanalwannenzone (6) und in einem Abstand von der Drift-Zone (5) angeordnet ist,
- eine Drain-Zone (8), die an der Oberfläche innerhalb der Drift-Zone (5) in einem Abstand von der Kanalwannenzone (6) angeordnet ist,
- eine Drain-Wannenzone (4) mit Leitfähigkeit des p-Typs, die sich unter der Drain-Zone (8) und unterhalb der Drift-Wannenzone (3) in der Körperwanne (2) befindet, und
- eine Gate-Elektrode (9), die über der Kanalwannenzone (6) auf einer Fläche der Kanalwannenzone (6) zwischen der Source-Zone (7) und der Drift-Zone (5) angeordnet ist, wobei die Gate-Elektrode (9) durch ein Gate-Dielektrikum (10) elektrisch vom Halbleitermaterial isoliert ist.

2. Hochspannungs-MOS-Transistorvorrichtung nach Anspruch 1, darüber hinaus umfassend:
- mindestens einen in das Substrat (1) integrierten, voll isolierten Hochspannungs-NMOS-Transistor,
- wobei die Drift-Wannenzone (3) für eine Drift-Zone des NMOS-Transistors vorgesehen ist, und
- ein Teil der Drain-Wannenzone (4) eine Körperwanne des NMOS-Transistors bereitstellt.

3. Hochspannungs-MOS-Transistorvorrichtung nach Anspruch 1 oder 2, darüber hinaus umfassend:
mindestens eine weitere Hochspannungsvorrichtung, die aus der Gruppe ausgewählt ist, die aus einem NMOS-Transistor, einem PMOS-Transistor, einer Diode und einem Bipolartransistor besteht, die in das Substrat (1) integriert sind, wobei die weitere Hochspannungsvorrichtung einen pn-Übergang umfasst, der durch die Drift-Wannenzone (3) und die Drain-Wannenzone (4) gebildet ist.

4. Hochspannungs-MOS-Transistorvorrichtung nach einem der Ansprüche 1 bis 3, wobei
eine vertikale Abmessung der Körperwanne (2), vertikal im Hinblick auf die Oberfläche des Substrats, größer als 7 µm ist, und
eine Tiefe der Drain-Wannenzone (4) zwischen 2 µm und 6 µm beträgt.

5. Verfahren zur Herstellung einer Hochspannungs-MOS-Transistorvorrichtung, Folgendes umfassend:
- Bereitstellen eines Halbleitersubstrats (1) mit einer Körperwanne (2) mit Leitfähigkeit des n-Typs,
- Implantieren eines für Leitfähigkeit des p-Typs vorgesehenen Dotiermittels in die Körperwanne (2) in einer geringeren Tiefe als die Körperwanne (2), und Ausbilden einer Drain-Wannenzone (4), die seitlich begrenzt ist,
- Implantieren eines für Leitfähigkeit des n-Typs vorgesehenen Dotiermittels in die Körperwanne (2) in einer geringeren Tiefe als die Drain-Wannenzone (4), und Ausbilden einer Drift-Wannenzone (3), wobei das Implantat, das die Drift-Wannenzone (3) bildet, den oberen Abschnitt der Drain-Wannenzone (4) gegendotiert,
- Implantieren eines für Leitfähigkeit des p-Typs vorgesehenen Dotiermittels in die Drift-Wannenzone (3) und Ausbilden einer Drift-Zone (5), und
- Ausbilden einer Kanalwannenzone (6) mit Leitfähigkeit des n-Typs angrenzend an die Drift-Zone (5), einer Source-Zone (7) innerhalb der Kanalwannenzone (6) und einer Drain-Zone (8) angrenzend an die Drift-Zone (5) und innerhalb der Fläche, die ursprünglich durch die Drain-Wannenzone (4) eingenommen wurde.

6. Verfahren nach Anspruch 5, darüber hinaus umfassend:
Aufwachsen einer Epitaxieschicht (13) aus Halbleitermaterial auf der Oberfläche des Substrats (1), nachdem die Körperwanne (2) bereitgestellt wurde und bevor die Drain-Wannenzone (4) implantiert wird, und
Bewirken einer Diffusion eines Dotiermittels aus der Körperwanne (2) in die Epitaxieschicht (13) nach dem Implantieren der Drain-Wannenzone (4).

7. Verfahren nach Anspruch 5 oder 6, wobei das für die Ausbildung der Drain-Wannenzone (4) vorgesehene Implantieren derart erfolgt, dass eine Drain-Wannenzone (4) eines PMOS-Transistors und eine tiefe Wanne eines NMOS-Transistors entstehen,
und
das für die Ausbildung der Drift-Wannenzone (3) vorgesehene Implantieren derart erfolgt, dass eine Drift-Wannenzone (3) eines PMOS-Transistors und eine Drift-Zone eines NMOS-Transistors entstehen.

## Revendications

1. Dispositif à transistor MOS haute tension comprenant :
- un puits de corps (2) de conductivité de type n positionné près d'une surface d'un substrat semi-conducteur (1),
- une région de puits de dérive (3) de conductivité de type n positionnée dans le puits de corps (2),
- une région de dérive (5) de conductivité de type p positionnée à la surface du substrat dans la région de puits de corps (3),
- une région de puits de canal (6) de conductivité de type n positionnée à la surface du substrat dans la région de puits de dérive (3) et contiguë à la région de dérive (5),
- une région de source (7) disposée à la surface à l'intérieur de la région de puits de canal (6) et à une distance de la région de dérive (5),
- une région de drain (8) disposée à la surface à l'intérieur de la région de dérive (5) à une distance de la région de puits de canal (6),
- une région de puits de drain (4) de conductivité de type p positionnée sous la région de drain (8) et en-dessous de la région de puits de dérive (3) dans le puits de corps (2), et
- une électrode de grille (9) disposée au-dessus de la région de puits de canal (6) sur une zone de la région de puits de canal (6) entre la région de source (7) et la région de dérive (5), l'électrode de grille (9) étant électriquement isolée du matériau semi-conducteur par un diélectrique de grille (10).

2. Le dispositif à transistor MOS haute tension de la revendication 1, comprenant en outré :
- au moins un transistor NMOS haute tension entièrement isolé étant intégré au substrat (1),
- la région de puits de dérive (3) étant prévue pour une région de dérive du transistor NMOS, et
- une portion de la région de puits de drain (4) présentant un puits de corps du transistor NMOS.

3. Le dispositif à transistor MOS haute tension de la revendication 1 ou 2, comprenant en outré :
au moins un dispositif haute tension supplémentaire choisi dans le groupe constitué d'un transistor NMOS, d'un transistor PMOS, d'une diode et d'un transistor bipolaire étant intégré au substrat (1), ledit dispositif haute tension supplémentaire englobant une jonction pn formée par la région de puits de dérive (3) et la région de puits de drain (4).

4. Le dispositif à transistor MOS haute tension selon l'une des revendications 1 à 3, où
une dimension verticale du puits de corps (2), verticale par rapport à la surface du substrat, est plus grande que 7 µm et
une profondeur de la région de puits de drain (4) est comprise entre 2 µm et 6 µm.

5. Procédé de production d'un dispositif à transistor MOS haute tension, comprenant :
- la fourniture d'un substrat semi-conducteur (1) avec un puits de corps (2) de conductivité de type n,
- l'implantation d'un dopant prévu pour une conductivité de type p dans le puits de corps (2) à une profondeur moins grande que le puits de corps (2) et la formation d'une région de puits de drain (4) qui est limitée latéralement,
- l'implantation d'un dopant prévu pour une conductivité de type n dans le puits de corps (2) à une profondeur moins grande que la région de puits de drain (4) et la formation d'une région de puits de dérive (3), où l'implant formant ladite région de puits de dérive (3) contredope la portion supérieure de ladite région de puits de drain (4),
- l'implantation d'un dopant prévu pour une conductivité de type p dans la région de puits de dérive (3) et la formation d'une région de dérive (5), et
- la formation d'une région de puits de canal (6) de conductivité de type n contiguë à la région de dérive (5), d'une région de source (7) à l'intérieur de la région de puits de canal (6), et d'une région de drain (8) contiguë à la région de dérive (5) et située à l'intérieur de la zone originellement occupée par la région de puits de drain (4).

6. Le procédé de la revendication 5, comprenant en outre :
la constitution d'une couche épitaxiale (13) de matériau semi-conducteur sur la surface du substrat (1), après avoir fourni le puits de corps (2) et avant l'implantation de la région de puits de drain (4), et la réalisation d'une diffusion d'un dopant à partir du puits de corps (2) dans la couche épitaxiale (13) après l'implantation de la région de puits de drain (4).

7. Le procédé de la revendication 5 ou 6, où l'implantation prévue pour la formation de la région de puits de drain (4) est réalisée de telle manière qu'une région de puits de drain (4) d'un transistor PMOS et un puits profond d'un transistor NMOS sont produits, et l'implantation prévue pour la formation de la région de puits de dérive (3) est réalisée de telle manière qu'une région de puits de dérive (3) d'un transistor PMOS et une région de dérive d'un transistor NMOS sont produits.
